# EUROPEAN PATENT SPECIFICATION

(11) **EP 0 867 998 B1**
(45) Date of publication and mention of the grant of the patent: **28.03.2007**
(21) Application number: 98102660.2
(22) Date of filing: 17.02.1998
(51) Int. Cl.: H02H 7/12, H02H 9/02

(54) **A plant for transmitting electric power**
Anlage zur elektrischen Leistungsübertragung
Installation pour la transmission de puissance électrique

(30) Priority: 24.03.1997 SE 9701065
(43) Date of publication of application: 30.09.1998
(73) Proprietor: ABB AB, 721 83 Västeras (SE)
(72) Inventor: Asplund, Gunnar, 771 32 Ludvika (SE)
(74) Representative: Olsson, Jan

(56) References cited:
- US-A- 5 317 499
- US-A- 5 561 579

## Description

### FIELD OF THE INVENTION AND PRIOR ART

The present invention relates to a plant for transmitting electric power comprising a direct voltage network for High Voltage Direct Current (HVDC) and at least one alternating voltage network connected thereto through a station, in which the station is adapted to perform transmitting of electric power between the direct voltage network and the alternating voltage network and comprises at least one VSC-converter adapted to convert direct voltage into alternating voltage and conversely.

Such a plant has recently been known through the thesis "PWM and control of two and three level high power voltage source converters" by Anders Lindberg, Kungliga Tekniska Högskolan, Stockholm, 1995, in which publication such a plant for transmitting electric power through a direct voltage network for High Voltage Direct Current (HVDC) is described. Before the issuance of said thesis plants for transmitting electric power through a direct voltage network for High Voltage Direct Current have been based upon the use of line-commutated CSC (Current Source Converter) converters in stations for power transmission. By the development of IGBTs (Insulated Gate Bipolar Transistor = bipolar transistor having an insulated gate) for high voltage applications and the suitability to connect them in series in valves in converters, since they may easily be turned on and turned off simultaneously, VSC (Voltage Source Converter) converters for forced commutation have now instead become an alternative, and this type of transmission of electric power between a direct voltage network for High Voltage Direct Current being voltage-stiff therethrough and alternating voltage networks connected thereto offers several important advantages with respect to the use of line-commutated CSCs in HVDC, of which it may be mentioned that the consumption of active and reactive power may be controlled independently of each other and there is no risk of commutation failures in the converter and by that no risk of transmission of commutation failures between different HVDC links, which may take place in line-commutated CSC. Furthermore, there is a possibility to feed a weak alternating voltage network or a network without a generation of its own (a dead alternating voltage network). Further advantages are also there.

However, in this new type of plants having no transformers a requirement occurs to be able to rapidly limit the current in the direct voltage network and also quickly interrupt the current, since the alternating voltage network now is through the VSC-converter directly connected to the direct voltage network, which may mean suddenly very high currents directly into the direct voltage network when for example a ground fault occurs there. It is often no acceptable solution to arrange mechanical breakers in the direct voltage network, since the time available for breaking the current may be to short for such a breaker.

### SUMMARY OF THE INVENTION

The invention is defined by the features of claim 1. Preferred embodiments of the invention are defined in the dependent claims.

The object of the present invention is to provide a plant of the type defined in the introduction, in which the problems mentioned above have been solved in a satisfying way.

This object is according to the invention obtained by connecting at least one parallel connection of at least one semiconductor element of turn-off type and a surge diverter in the direct voltage network of such a plant.

By having such a parallel connection connected in the direct voltage network the current through the direct voltage network may very rapidly be limited, since such a semiconductor element may be turned off very rapidly, should there be a need thereof, by turning the semiconductor element off. When the surge diverter is suitably dimensioned, i.e. the voltage level at which it becomes conducting, the current in the direct voltage network may also be broken by turning the semiconductor element off. The electric energy absorbed by the parallel connection will substantially as a whole be absorbed by the surge diverter and the semiconductor element will be protected against over currents.

According to a preferred embodiment of the invention the plant is of such a type that the current through the direct voltage network may assume two possible directions, and said semiconductor elements of the parallel connection are two to the number and connected in series with oppositely directed conducting directions, and a separate rectifier diode is connected in anti-parallel with each of the semiconductor elements. By connecting such a parallel connection of semiconductor elements, rectifier diodes and surge diverters in the direct voltage network the advantageous current limiting and current breaking function mentioned above may safely be obtained also in the case in which it would not be totally clear which is the current direction in the direct voltage network existing at a given instant, which may be the case in a so called meshed network. Thus, in such a case a controlling, i.e. turning on or turning off, of the two semiconductor elements takes place simultaneously.

According to another preferred embodiment of the invention the plant comprises an apparatus adapted to turn the semiconductor elements of the parallel connection off when the current therethrough exceeds a predetermined level. At least a current limitation in the direct voltage network takes place by this and depending upon the voltage thereacross and the dimensioning of the surge diverter the current is broken.

According to another preferred embodiment of the invention said apparatus is adapted, when the current in the direct voltage network exceeds a predetermined level, to start to alternatingly turn the semiconductor elements of the parallel connection off and on with a frequency adapted for adjusting the current in the direct voltage network to not exceed a maximum level. By such an alternating turning the semiconductor elements off and on the current in the direct voltage network may be adjusted to a desired level and accordingly the current be restricted in a desired way. The intensity of the current will depend upon the relationship between the lengths of the turn-off and the turn-on times of the semiconductor elements of the parallel connection.

According to another preferred embodiment of the invention the plant comprises a plurality of said parallel connections connected in the direct voltage network. By arranging a plurality of such parallel connections and appropriately choosing this plurality, it will be possible to limit the current through the direct voltage network differently strong by a different number of semiconductor elements and by turning sufficiently many of them off break the current.

According to another preferred embodiment of the invention, which constitutes a further development of the embodiment last mentioned, said apparatus is adapted, when the current in the direct voltage network exceeds a predetermined level, to alternatingly turn the different semiconductor elements on and off according to a pattern determined in dependence upon the intensity of said current for adjusting the current through the direct voltage network to not exceed a predetermined allowed maximum level. The current in the direct voltage network may by this with a high reliability be limited to not exceed a maximum level allowed. By alternatingly turning the semiconductor elements on and off and by that alternatingly conduct the current through the semiconductor elements and the surge diverter it is at the same time obtained that the large amount of electric energy which may be transmitted to the direct voltage network, for example in a ground fault, may be taken care of by the surge diverters.

According to another preferred embodiment of the invention the apparatus is adapted, when the current in the direct voltage network exceeds a predetermined level, to turn such a great number of semiconductor elements off that the corresponding number of surge diverters manage to take the voltage to be taken by the direct voltage network and the current in the direct voltage network is broken. By turning a sufficiently great number of semiconductor elements off in this way in a plant having a plurality of said parallel connections connected in the direct voltage network, a very fast breaking of the current in the direct voltage network may be achieved, should this be necessary in cases of faults lasting.

According to another preferred embodiment of the invention the apparatus is adapted to carry out said turning on and turning off at a frequency in the kHz-region. It is advantageous to carry out said alternating turning of the semiconductor elements on and off for obtaining an appropriate current limiting effect with such a frequency that is located at substantially the same level as the frequency through which the semiconductor elements in the current valves of the VSC-converter are controlled. This means that the apparatus may follow the VSC-converter and may obtain an appropriate restriction of the current through the direct voltage network.

Further advantages as well as advantageous features of the invention will appear from the following description and the other dependent claims.

### BRIEF DESCRIPTION OF THE DRAWING

With reference to the appended drawing, below follows a description of preferred embodiments of the invention cited as examples.

In the drawing:
- Fig 1: is a very schematic diagram of a part of a plant according to a first preferred embodiment of the invention,
- Fig 2: is a diagram of a detail of a plant according to a second preferred embodiment of the invention,
- Fig 3: is a diagram simplified with respect to Fig 1 of a part of a plant according to a third preferred embodiment of the invention, and
- Fig 4: is a graph illustrating the current through the direct voltage network in the plant according to Fig 3 in function of the number of semiconductor elements turned off, i.e. surge diverters connected in series, in the direct voltage network.

### DETAILED DESCRIPTION OF PREFERRED EMBODIMENTS OF THE INVENTION

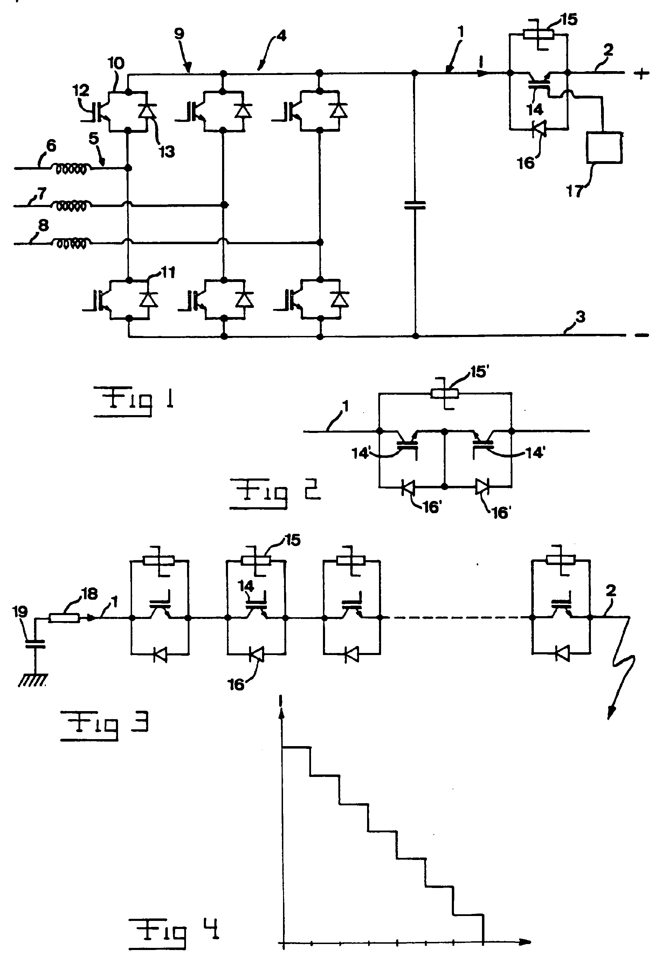

The structure of a plant for transmitting electric power according to a first preferred embodiment of the invention is very schematically and simplified illustrated in Fig 1, in which mainly only the different components having directly something to do with the function according to the invention have been shown in the drawing so as to facilitate the comprehension of the invention. The plant comprises a direct voltage network 1 for High Voltage Direct Current (HVDC = High Voltage Direct Current) having two pole conductors or lines 2, 3 and an alternating voltage network 5 connected to the direct voltage network through a station 4, said alternating voltage network having in the present case three phases 6, 7, 8. The station is designed to perform transmittance of electric power between the direct voltage network 1 and the alternating voltage network 5, in which the power may be fed in from the alternating voltage network to the direct voltage network or fed out from the direct voltage network to the alternating voltage network. Thus, the alternating voltage network may have generators of electric power or only be connected to consumers thereof. The station comprises at least one VSC-converter 9 adapted to convert direct voltage into alternating voltage and conversely. However, it is completely possible that the station comprises a plurality of such converters. The VSC-converter comprises in a conventional way one phase leg for each phase with two so called current valves 10, 11, which consist of branches of breakers 12 of turn-on and turn-off type, preferably in the form of IGBTs, connected in series and diodes 13 connected in anti-parallel therewith. A great number of IGBTs may then be connected in series in one single valve so as to be turned on and turned off simultaneously so as to function as one single breaker, wherethrough the voltage across the valve is distributed among the different breakers connected in series. The control of the breakers takes place in a conventional way trough pulse width modulation (PWM).

The plant comprises a parallel connection of a semiconductor element 14 of turn-off type which may be of any type having an ability of breaking the current therethrough, such as an IGBT, GTO, MOSFET etc., and a surge diverter 15 connected in the direct voltage network. A rectifier diode 16 is also connected in anti-parallel with the semiconductor element 14. In the case of a plant of this type having two pole conductors of the direct voltage network the second pole conductor has also such a parallel connection, although it is not shown in Fig 1. The surge diverter 15 is of a conventional type, such as a zinc oxide diverter, and it conducts normally a very low current, but when the voltage thereover exceeds a certain level it will take a strongly increased current. The plant comprises also an apparatus 17 adapted to turn the semiconductor element 14 off, when the current therethrough exceeds a predetermined level. More exactly, the semiconductor element 14 will in normal operation be turned on, but when any fault occurs in the plant, such as a ground fault in the direct voltage network, and the voltage drop over the direct voltage network is great with a risk of high currents therethrough, the apparatus 17 begins alternatingly to turn the semiconductor elements 14 on and off with a comparatively high frequency (in the range of some kHz), so that the current I through the direct voltage network will be commutated between the semiconductor element 14 and the surge diverter 15 and by that a current limiting effect will be obtained. The intensity of the resulting current will depend upon the relationship between the lengths of the turn-off times and turn-on times of the semiconductor element 14. Depending upon the existing voltages and the dimension of the surge diverter 15 it could be made possible that the apparatus 17 may break the current I in the direct voltage network by transferring the semiconductor element 14 to a permanently turn-off state.

An alternative to the parallel connection shown in Fig 1 is shown in Fig 2, which differs from that according to Fig 1 by the presence of two semiconductor elements 14' connected in series with oppositely directed conducting directions, and a separate rectifier diode 16' is connected in anti-parallel with each of the semiconductor elements. It is the intention that the semiconductor elements 14' shall be turned off and turned on simultaneously, which makes it possible to obtain the function of the parallel connection described in connection with Fig 1 irrespectively of the direction of the current in the direct voltage network 1. A parallel connection of this type is arranged where the current through the direct voltage network may assume two possible directions, i.e. it is not known for sure which current direction is prevailing, which is the case in so called meshed networks.

A plant according to a third preferred embodiment of the invention is illustrated in Fig 3, in which this is slightly simplified with respect to Fig 1. The real difference between this plant and that according to Fig 1 is that the plant in Fig 3 has a plurality of parallel connections of semiconductor elements 14, surge diverters 15 and rectifier diodes 16 connected in the direct voltage network. The total resistance of the system has here also been illustrated through a resistor 18. The direct voltage network in this plant has only one pole conductor 2. The voltage U_{d} of the direct voltage network is lying across the capacitor 19. When a fault case occurs, such as a ground fault schematically indicated, the voltage over the direct voltage network between the station and the ground fault will be very high and when semiconductor elements 14 are turned on in principle be defined by the resistance of the system represented by the resistor 18. By alternatingly at a high frequency through the apparatus 17 not shown in the way described above turn the different semiconductor elements on and off according to a predetermined pattern depending upon the magnitude of the voltage and by that the over current, the current through the direct voltage network may be limited to an acceptable level. By simultaneously turn a sufficiently great number of semiconductor elements off, the current through the direct voltage network may also be broken completely.

It is illustrated in Fig 4 how the current I through the direct voltage network is changed with the number of surge diverters connected in series, i.e. the number of semiconductor elements turned off at the same time. When no semiconductor elements are turned off the current is equal to the voltage U_{d}/R, in which R is the resistance of the resistor 18. Thus, in the case shown in Fig 4 a simultaneous turning off of seven semiconductor elements would be required so as to completely break the current in the direct voltage network.

Said parallel connections of the plants according to the invention are preferably controlled so that they restrict the current during certain transient fault cases, but if these fault cases remain they break the current. These parallel connections would most often be arranged in connection with the stations for control by the control apparatus also taking care of the control of the converter of the station, but it is also within the scope of the invention to arrange them out in the very direct voltage network, especially in so called meshed networks.

The invention is of course not in any way restricted to the preferred embodiments described above, but many possibilities to modifications thereof would be apparent to a man skilled in the art without departing from the basic idea of the invention, such as this is defined in the claims.

The type of parallel connection illustrated in Fig 2 may for example be used in a plant of the type shown in Fig 3 for use especially in so called meshed networks.

## Claims

1. A plant for transmitting electric power comprising a direct voltage network (1) for High Voltage Direct Current (HVDC) and at least one alternating voltage network (5) connected thereto through a station, in which the station is adapted to perform transmitting of electric power between the direct voltage network and the alternating voltage network and comprises at least one VSC-converter (9) adapted to convert direct voltage into alternating voltage and conversely,
**characterized in that** in the direct voltage network at least a parallel connection of at least a semiconductor element (14, 14') of turn-off type and a surge diverter (15, 15') is connected.

2. A plant according to claim 1, in which the current through the direct voltage network (1) may assume two possible directions,
**characterized in that** said semiconductor elements (14') of the parallel connection are two to the number and connected in series with oppositely directed conducting directions, and that a separate rectifier diode (16') is connected in anti-parallel with each of the semiconductor elements.

3. A plant according to claim 1 or 2,
**characterized in that** it comprises an apparatus (17) adapted to turn the semiconductor elements (14, 14') of the parallel connection off when the current therethrough exceeds a predetermined level.

4. A plant according to claim 3,
**characterized in that** said apparatus (17) is adapted, when the current in the direct voltage network exceeds a predetermined level, to start to alternatingly turn the semiconductor elements (14, 14') of the parallel connection off and on with a frequency adapted for adjusting the current in the direct voltage network to not exceed a maximum level.

5. A plant according to any of claims 1-4,
**characterized in that** it comprises a plurality of said parallel connections connected in the direct voltage network (1).

6. A plant according to claims 3 and 5,
**characterized in that** said apparatus (17) is adapted, when the current in the direct voltage network (1) exceeds a predetermined level, to alternatingly turn the different semiconductor elements (14, 14') on and off according to a pattern determined in dependence upon the intensity of said current for adjusting the current through the direct voltage network to not exceed a predetermined allowed maximum level.

7. A plant according to claim 3,
**characterized in that** the apparatus (17) is adapted to turn the semiconductor elements (14, 14') of the parallel connection off when the current therethrough exceeds a predetermined level so as to break the current in the direct voltage network.

8. A plant according to claims 3 and 5,
**characterized in that** said apparatus (17) is adapted, when the current in the direct voltage network exceeds a predetermined level, to turn such a great number of semiconductor elements (14, 14') off that the corresponding number of surge diverters manage to take the voltage to be taken by the direct voltage network and the current in the direct voltage network is broken.

9. A plant according to claim 4 or 6,
**characterized in that** the apparatus (17) is adapted to carry out turning on and turning off with a frequency in kHz-region.

## Patentansprüche

1. Anlage zur Übertragung elektrischen Stromes, die ein Gleichspannungsnetz (1) für Hochspannungsgleichstrom (HVDC) umfasst und mindestens ein Wechselspannungsnetz (5), das über eine Station daran angeschlossen ist, wobei die Station dafür eingerichtet ist, Übertragungen elektrischen Stroms zwischen dem Gleichspannungsnetz und dem Wechselspannungsnetz auszuführen und mindestens einen VSC-Umrichter (9) umfasst, der dazu in der Lage ist, Gleichspannung in Wechselspannung zu transformieren und umgekehrt,
**dadurch gekennzeichnet, dass** mindestens eine Parallelschaltung mindestens eines Absperrhalbleiterbauteils (14, 14') und eines Überspannungsableiters (15, 15') im Gleichspannungsnetzwerk angeschlossen ist.

2. Anlage nach Patentanspruch 1, in der der das Gleichspannungsnetz (1) durchfließende Strom zwei mögliche Richtungen annehmen kann, **dadurch gekennzeichnet, dass** es zwei genannte Halbleiterbauteile (14') der Parallelschaltung gibt, die mit entgegengesetzten Leitungsrichtungen in Reihe geschaltet sind, und dass eine gesonderte Gleichrichterdiode (16') antiparallel zu jedem der Halbleiterbauteile geschaltet ist.

3. Anlage nach Patentanspruch 1 oder 2, **dadurch gekennzeichnet, dass** sie eine Vorrichtung (17) umfasst, die dafür ausgelegt ist, die Halbleiterbauteile (14, 14') der Parallelschaltung zu sperren, wenn der sie durchfließende Strom eine festgelegte Stärke übersteigt.

4. Anlage nach Patentanspruch 3, **dadurch gekennzeichnet, dass** die genannte Vorrichtung (17) dafür eingerichtet ist, in dem Fall, dass der Strom im Gleichspannungsnetz eine Stärke übersteigt, die Halbleiterbauteile (14, 14') der Parallelschaltung mit einer Frequenz zu sperren und zu öffnen, die dazu geeignet ist, den Strom im Gleichspannungsnetz derart zu regeln, dass er eine maximale Stärke nicht übersteigt.

5. Anlage nach irgendeinem der Patentansprüche 1 bis 4, **dadurch gekennzeichnet, dass** sie mehrere der genannten Parallelschaltungen, im Gleichspannungsnetz (1) angeschlossen, umfasst.

6. Anlage nach Patentanspruch 3 und 5, **dadurch gekennzeichnet, dass** die genannte Vorrichtung (17) dafür eingerichtet ist, in dem Fall, dass der Strom im Gleichspannungsnetz eine vorbestimmte Stärke übersteigt, die Halbleiterbauteile (14, 14') der Parallelschaltung in einem Rhythmus zu sperren und zu öffnen, der in Abhängigkeit von der Stärke des genannten Stromes bestimmt wird, um den Strom im Gleichspannungsnetz derart zu regeln, dass er eine bestimmte zulässige maximale Stärke nicht übersteigt.

7. Anlage nach Patentanspruch 3, **dadurch gekennzeichnet, dass** die Vorrichtung (17) dafür ausgelegt ist, die Halbleiterbauteile (14, 14') der Parallelschaltung zu sperren, wenn der sie durchfließende Strom eine festgelegte Stärke übersteigt, um den Strom im Gleichspannungsnetz zu unterbrechen.

8. Anlage nach Patentanspruch 3 und 5, **dadurch gekennzeichnet, dass** die Vorrichtung (17) dafür ausgelegt ist, in dem Fall, dass der Strom im Gleichspannungsnetz eine vorbestimmte Stärke übersteigt, eine ausreichende Anzahl an Halbleiterbauteilen (14, 14') zu sperren, dass die entsprechende Anzahl an Überspannungsableitern in der Lage ist, die vom Gleichspannungsnetz aufzunehmende Spannung aufzunehmen und der Strom im Gleichspannungsnetz unterbrochen wird.

9. Anlage nach Patentanspruch 4 oder 6, **dadurch gekennzeichnet, dass** die Vorrichtung (17) dafür ausgelegt ist, das Öffnen und Sperren mit einer Frequenz im kHz-Bereich auszuführen.

## Revendications

1. Equipement pour transmettre la puissance électrique comprenant un réseau (1) en courant continu pour du courant continu à haute tension (HVDC) et au moins un réseau (5) en courant alternatif connecté au premier par une station, où la station est apte à réaliser la transmission de la puissance électrique entre le réseau à tension continue et le réseau à tension alternative et comprenant au moins un convertisseur VSC (9) apte à convertir la tension continue en tension alternative et inversement, **caractérisé en ce qu'**au moins une connexion parallèle d'au moins un élément semi-conducteur (14, 14') de type arrêt et d'un déviateur de surtension (15, 15') est connectée au réseau à tension continue.

2. Equipement selon la revendication 1, dans lequel le courant à travers le réseau à tension continue (1) peut suivre deux directions possibles, **caractérisé en ce que** lesdits éléments semi-conducteurs (14') de la connexion parallèle sont au nombre de deux et connectés en série avec des directions opposées de conduction directe, et **en ce qu'**une diode rectificatrice séparée (16') est connectée en anti-parallèle avec chacun des éléments semi-conducteurs.

3. Equipement selon la revendication 1 ou 2, **caractérisé en ce qu'**il comprend un appareil (17) apte à éteindre les éléments semi-conducteurs (14, 14') de la connexion parallèle quand le courant y circulant dépasse un niveau pré-déterminé.

4. Equipement selon la revendication 3, **caractérisé en ce que** ledit appareil (17) est apte, quand le courant dans le réseau à tension continue dépasse un niveau prédéterminé, à commencer à éteindre et allumer alternativement les éléments semi-conducteurs (14, 14') de la connexion parallèle avec une fréquence apte à ajuster le courant du réseau à tension continue à ne pas dépasser un niveau maximal.

5. Equipement selon l'une quelconque des revendications 1 à 4, **caractérisé en ce qu'**il comprend une pluralité des dites connexions parallèles connectées dans le réseau à tension continue (1).

6. Equipement selon les revendications 3 et 5, **caractérisé en ce que** ledit appareil (17) est apte, quand le courant dans le réseau à tension continue (1) dépasse un niveau prédéterminé, à allumer et à éteindre alternativement les différents éléments semi-conducteurs (14, 14') selon un modèle déterminé en fonction de l'intensité dudit courant pour ajuster le courant à travers le réseau à tension continue à ne pas dépasser un niveau maximal autorisé prédéterminé.

7. Equipement selon la revendication 3, **caractérisé en ce que** l'appareil (17) est apte à éteindre les éléments semi-conducteurs (14, 14') de la connexion parallèle quand le courant y circulant dépasse un niveau prédéterminé de façon à couper le courant dans le réseau à tension continue.

8. Equipement selon les revendications 3 et 5, **caractérisé en ce que** ledit appareil (17) est apte, quand le courant dans le réseau à tension continue dépasse un niveau prédéterminé, à éteindre un nombre si grand d'éléments semi-conducteurs (14, 14') que le nombre correspondant de déviateurs de surtension parvient à prélever le courant devant être prélevé par le réseau à tension continue et que le courant dans le réseau à tension continue est coupé.

9. Equipement selon la revendication 4 ou 6, **caractérisé en ce que** l'appareil (17) est apte à réaliser l'allumage et l'extinction avec une fréquence de l'ordre du kHz.
